# EUROPEAN PATENT APPLICATION

(11) **EP 4 848 591 A1**
(43) Date of publication of application: **02.12.2026**
(21) Application number: 26179325.1
(22) Date of filing: 18.05.2026
(51) Int. Cl.: H03L 7/081, H03L 7/089, H03L 7/091, H03L 7/093, H03L 7/095

(54) **SYSTEMS AND METHODS FOR CLOCK SIGNAL SYNCHRONIZATION USING FALSE-LOCKING DETECTION**

(30) Priority: 30.05.2025 US 202519223908
(71) Applicant: Avago Technologies International Sales Pte. Limited, Singapore 768923 (SG)
(72) Inventor: Wang, Rui, Irvine, 92620 (US); Caresosa, Mario, San Clemente, 92673 (US); Lee, Seong-Ho, Aliso Viejo, 92656 (US)
(74) Representative: Dilg, Haeusler, Schindelmann Patentanwaltsgesellschaft mbH

(57) **Abstract**

The subject technology is directed to electronic circuits. In an embodiment, the subject technology provides an apparatus that includes a first circuit configured to receive an input clock signal and to generate an output clock signal by providing a first delay to the input clock signal. A second circuit is configured to provide a first signal indicative of a propagation distance of the input clock signal. A first detector is configured to generate a second signal based on a phase difference between the input clock signal and the output clock signal. A second detector is configured to determine a locking condition based on the first signal and to generate a third signal. The apparatus further includes a controller configured to adjust the first delay based on at least one of the second signal and the third signal. There are other embodiments as well.

## Description

### FIELD OF INVENTION

The subject technology is directed to electronic circuits.

### BACKGROUND OF THE INVENTION

In timing control systems, clock alignment circuits play an important role in maintaining phase synchronization across various components of a system. For example, delay-locked loop (DLL) circuits are widely used in applications such as high-speed data interfaces, memory systems, and communication devices, where accurate clock alignment is beneficial for maintaining data integrity and system timing.

In various implementations, a DLL may include a delay circuit and a feedback control system that adjusts the delay based on the phase difference between the input clock signal and the output clock signal. However, challenges may arise when the delay circuit enters a locking condition that does not correspond to the desired timing relationship. For example, a stuck locking condition may occur when the applied delay is too small relative to the clock period. A harmonic locking condition may occur when the applied delay corresponds to an integer multiple of the intended clock period, rather than to a single clock period. These false locking conditions may result in timing errors and degraded system performance.

Various approaches have been explored to facilitate clock signal alignment, but they have proven to be insufficient. It is important to recognize the need for new and improved systems and methods.

### BRIEF DESCRIPTION OF THE DRAWINGS

A further understanding of the nature and advantages of particular embodiments may be realized by reference to the remaining portions of the specification and the drawings, in which reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a block diagram illustrating a delay-locked loop (DLL) system, in accordance with various embodiments of the subject technology.
Figure 2 is a timing diagram illustrating correct locking and harmonic locking conditions, in accordance with various embodiments of the subject technology.
Figure 3A is a block diagram illustrating a phase detection system, in accordance with various embodiments of the subject technology.
Figure 3B is a timing diagram illustrating correct locking and stuck locking conditions, in accordance with various embodiments of the subject technology.
Figure 4 is a block diagram illustrating a delay-locked loop (DLL) system, in accordance with various embodiments of the subject technology.
Figure 5 is a circuit diagram illustrating a false-locking detector (FLD), in accordance with various embodiments of the subject technology.
Figure 6A is a circuit diagram illustrating a false-locking detector (FLD) for detecting stuck locking, in accordance with various embodiments of the subject technology.
Figure 6B is a timing diagram illustrating a stuck locking condition, in accordance with various embodiments of the subject technology.
Figures 7A-7B are circuit diagrams illustrating a false-locking detector (FLD) for detecting harmonic locking, in accordance with various embodiments of the subject technology.
Figure 7C is a timing diagram illustrating a harmonic locking condition, in accordance with various embodiments of the subject technology.
Figure 8 is a block diagram illustrating a delay-locked loop (DLL) system, in accordance with various embodiments of the subject technology.
Figure 9A is a graph illustrating the transfer curve of a false-locking-detector-assisted Phase Frequency Detector (PFD) with annotated correct locking and false locking points, in accordance with various embodiments of the subject technology.
Figure 9B is a timing diagram illustrating an example of leaving harmonic locking for correct locking, in accordance with various embodiments of the subject technology.
Figure 9C is a timing diagram illustrating an example of leaving stuck locking for correct locking, in accordance with various embodiments of the subject technology.
Figure 10 is a diagram illustrating a comparison of two calibration methods of searching for the correct fixed delay code, in accordance with various embodiments of the subject technology.

### DETAILED DESCRIPTION

The subject technology is directed to electronic circuits. In an embodiment, the subject technology provides an apparatus that includes an input terminal configured to receive an input clock signal. The apparatus further includes a first circuit coupled to the input terminal and configured to generate an output clock signal by providing a first delay to the input clock signal. The apparatus further includes a second circuit coupled to the first circuit, the second circuit being configured to sample propagation of the input clock signal within the first circuit and provide a first signal indicative of a propagation distance of the input clock signal. The apparatus further includes a first detector coupled to the first circuit and configured to determine a phase difference between the input clock signal and the output clock signal and to generate a second signal based on the phase difference. The apparatus further includes a second detector coupled to the second circuit, the second detector being configured to determine a locking condition based on the first signal and to generate a third signal based on the locking condition. The apparatus further includes a controller coupled to the first detector and the second detector, the controller being configured to generate a control signal based on at least one of the second signal and the third signal to adjust the first delay. By detecting locking conditions based on propagation behavior and forcing the delay into correct locking points, the apparatus avoids false locking points. There are other embodiments as well.

The following description is presented to enable one of ordinary skill in the art to make and use the invention and to incorporate it in the context of particular applications. Various modifications, as well as a variety of uses in different applications, will be readily apparent to those skilled in the art, and the general principles defined herein may be applied to a wide range of embodiments. Thus, the subject technology is not intended to be limited to the embodiments presented but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of" or "act of" in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes an apparatus, which comprises a first circuit configured to receive an input clock signal and to generate an output clock signal by providing a first delay to the input clock signal. The apparatus further comprises a second circuit coupled to the first circuit and configured to sample propagation of the input clock signal within the first circuit and provide a first signal indicative of a propagation distance of the input clock signal. The apparatus further comprises a first detector coupled to the first circuit, the first detector being configured to determine a phase difference between the input clock signal and the output clock signal and to generate a second signal based on the phase difference. The apparatus further comprises a second detector coupled to the second circuit, the second detector being configured to determine a locking condition based on the first signal and to generate a third signal based on the locking condition. The apparatus further comprises a controller coupled to the first detector and the second detector, the controller being configured to generate a control signal based on at least one of the second signal and the third signal, the control signal being configured to adjust the first delay.

Implementations may include one or more of the following features. The first circuit comprises a first stage configured to generate a first intermediate clock signal by providing a second delay to the input clock signal. The second circuit comprises a first sampling element coupled to the first stage and configured to sample the first intermediate clock signal and generate a first sampled value. The first signal comprises the first sampled value from the first sampling element. The apparatus further comprises a charge pump coupled to the controller and the first circuit, the charge pump being configured to adjust a control voltage applied to the first circuit based on the control signal. The locking condition comprises a stuck locking condition or a harmonic locking condition. The second detector is configured to compare the propagation distance of the input clock signal to a first threshold and to determine the stuck locking condition in response to the propagation distance being less than the first threshold. The second detector is configured to compare the propagation distance of the input clock signal to a second threshold and to determine the harmonic locking condition in response to the propagation distance being greater than the second threshold. The controller is configured to generate the control signal based on the third signal in response to a determination of the locking condition. The controller comprises a multiplexer.

According to another embodiment, the subject technology provides an apparatus, which comprises a first circuit configured to receive an input clock signal and to generate an output clock signal by providing a first delay to the input clock signal. The apparatus further comprises a second circuit coupled to the first circuit and configured to sample propagation of the input clock signal within the first circuit and provide a first signal indicative of a propagation distance of the input clock signal. The apparatus further comprises a first detector coupled to the first circuit, the first detector being configured to determine a phase difference between the input clock signal and the output clock signal and to generate a second signal based on the phase difference. The apparatus further comprises a second detector coupled to the second circuit, the second detector being configured to determine a locking condition based on the first signal and to generate a third signal based on the locking condition. The apparatus further comprises a controller coupled to the first detector and the second detector, the controller being configured to adjust the first delay based on at least one of the second signal and the third signal.

Implementations may include one or more of the following features. The first circuit comprises a first stage configured to generate a first intermediate clock signal by providing a second delay to the input clock signal. The second circuit comprises a first sampling element coupled to the first stage and configured to sample the first intermediate clock signal and generate a first sampled value. The first signal comprises the first sampled value from the first sampling element. The second detector is configured to compare the propagation distance of the input clock signal to a first threshold and to determine a stuck locking condition in response to the propagation distance being less than the first threshold. The second detector is configured to compare the propagation distance of the input clock signal to a second threshold and to determine a harmonic locking condition in response to the propagation distance being greater than the second threshold. The controller is configured to generate a control signal based on the third signal in response to a determination of the locking condition.

According to yet another embodiment, the subject technology provides an apparatus, which comprises a first circuit configured to receive an input clock signal and to generate an output clock signal by providing a first delay to the input clock signal. The apparatus further comprises a second circuit coupled to the first circuit and configured to sample propagation of the input clock signal within the first circuit and provide a first signal indicative of a propagation distance of the input clock signal. The apparatus further comprises a first detector coupled to the first circuit, the first detector being configured to determine a phase difference between the input clock signal and the output clock signal and to generate a second signal based on the phase difference. The apparatus further comprises a second detector coupled to the second circuit, the second detector being configured to determine a locking condition based on the first signal and to generate a third signal based on the locking condition. The apparatus further comprises a controller coupled to the first detector and the second detector, the controller being configured to generate a control signal based on at least one of the second signal and the third signal. The apparatus further comprises a charge pump coupled to the controller and the first circuit, the charge pump being configured to adjust the first delay by applying a control voltage to the first circuit based on the control signal. In various embodiments, the locking condition comprises a stuck locking condition or a harmonic locking condition. The second detector is configured to compare the propagation distance of the input clock signal to a first threshold and to determine the stuck locking condition in response to the propagation distance being less than the first threshold. The second detector is configured to compare the propagation distance of the input clock signal to a second threshold and to determine the harmonic locking condition in response to the propagation distance being greater than the second threshold. The controller comprises a multiplexer.

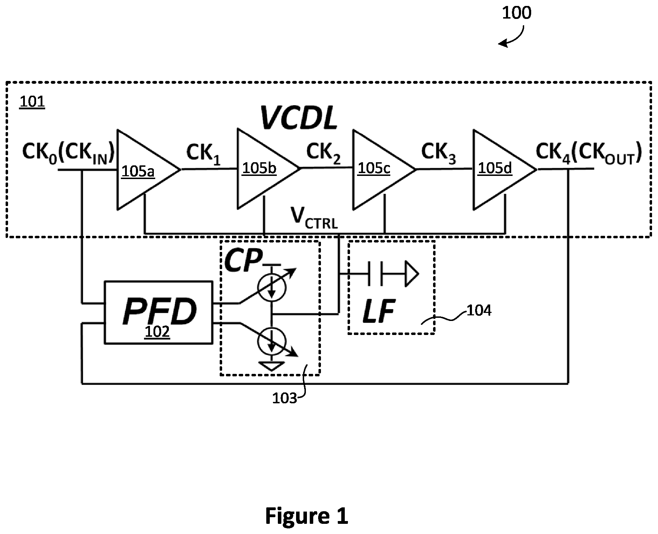

Figure 1 is a block diagram illustrating a delay-locked loop (DLL) system 100, in accordance with various embodiments of the subject technology. This diagram merely provides an example, which should not unduly limit the scope of the claims. One of ordinary skill in the art would recognize many variations, alternatives, and modifications. For example, the term "delay-locked loop" may refer to an electronic circuit configured to generate an output clock signal with precise timing relative to a reference clock signal. System 100 may be implemented in various applications, such as memory interfaces, high-speed transceivers, networking switches, and/or the like. Depending on the application, system 100 may incorporate various features such as delay adjustment, false-locking detection, calibration support, and/or the like.

As shown, system 100 includes at least one of circuit 101, detector 102, charge pump 103, filter 104, and/or the like. In some embodiments, circuit 101 may be configured to receive an input clock signal (e.g., CK₀ (CK_{IN})) and generate an output clock signal (e.g., CK₄ (CK_{OUT})) to achieve phase alignment with the input clock signal. For example, circuit 101 may include a voltage-controlled delay line (VCDL), a digitally-controlled delay line (DCDL), a programmable delay line, propagation delay circuits, phase-shifting networks, and/or the like. The term "clock signal" may refer to any periodic signal used for timing or synchronization purposes within a system or circuit. Depending on the implementation, the input clock signal may be adjustable, programmable, or derived from other timing sources.

In some embodiments, circuit 101 may generate the output clock signal by providing a first delay to the input clock signal. By adjusting the first delay, circuit 101 enables the output clock signal to achieve a desired timing relationship (e.g., 1 clock period or 1T_{CK}) relative to the input clock signal. For instance, the term "delay" may refer to a controlled time shift applied to a signal. In some examples, circuit 101 may include one or more stages (e.g., stages 105a-d), which may be coupled in series to form the complete delay line of the DLL. For example, the term "stage" may refer to a delay element configured to introduce a defined delay to an input signal. In various embodiments, a stage may include a buffer, an inverter, a differential amplifier, a flip-flop, a latch, a pass-gate delay cell, a resistor-capacitor (RC) delay element, and/or the like.

Each stage may be configured to receive an intermediate clock signal and generate a delayed version of the signal for the next stage. For example, stage 105a generates an intermediate clock signal CK₁ (e.g., by providing a second delay to CK₀), stage 105b generates CK₂, stage 105c generates CK₃, and stage 105d generates the final output clock signal CK₄. Each intermediate clock signal (e.g., CK₁-CK₄) represents the propagated version of the input clock signal after passing through a corresponding number of delay stages.

According to various implementations, detector 102 may be coupled to circuit 101 and configured to determine a phase difference between the input clock signal (e.g., CK₀) and the output clock signal (e.g., CK₄). For example, the term "detector" may refer to a circuit configured to measure a characteristic or condition of one or more signals. For example, detector 102 may include a phase-frequency detector (PFD), a phase detector (PD), an edge detector, a timing comparator, and/or the like. The term "phase difference" may refer to the timing offset or temporal displacement between two signals, which may be measured in degrees or time units. As an example, detector 102 may receive the input clock signal (e.g., CK₀) and the output clock signal (e.g., CK₄) and generate phase comparison signals indicative of whether CK₄ leads or lags CK₀, thereby enabling the feedback system to correct for phase misalignment.

In some embodiments, charge pump 103 may be coupled to detector 102 and configured to receive the phase comparison signals from detector 102. For example, the term "charge pump" may refer to an electronic circuit configured to generate an output current or voltage based on control signals (e.g., by sourcing or sinking charge into a downstream load). Examples of charge pumps may include, without limitation, differential charge pumps, source-switched charge pumps, and/or the like. In some cases, charge pump 103 may be configured to generate a control voltage (e.g., V_{CTRL}) based on the phase comparison signals from detector 102. The control voltage tunes the delay elements (e.g., stages 105a-d) in circuit 101 to align the output clock phase with the input clock.

According to various implementations, filter 104 may be coupled to charge pump 103 and configured to filter the output signal generated by charge pump 103. For example, the term "filter" may refer to a circuit configured to generate a stabilized output by suppressing unwanted signal variations. Examples of filters may include, without limitation, loop filters, low-pass filters, band-pass filters, and/or the like. In some aspects, filter 104 may be configured to condition the control voltage (e.g., V_{CTRL}) to remove noise and to provide a stable voltage to circuit 101.

In operation, system 100 continuously adjusts the control voltage (e.g., V_{CTRL}) based on the detected phase difference between the input clock signal (e.g., CK₀) and the output clock signal (e.g., CK₄) to maintain phase alignment. For example, if CK₄ lags behind CK₀, V_{CTRL} may be adjusted to decrease the first delay; if CK₄ leads CK₀, V_{CTRL} may be adjusted to increase the first delay. This feedback operation ensures that the output clock signal maintains a precise and stable phase relationship with the input clock signal across changing environmental conditions and operational modes.

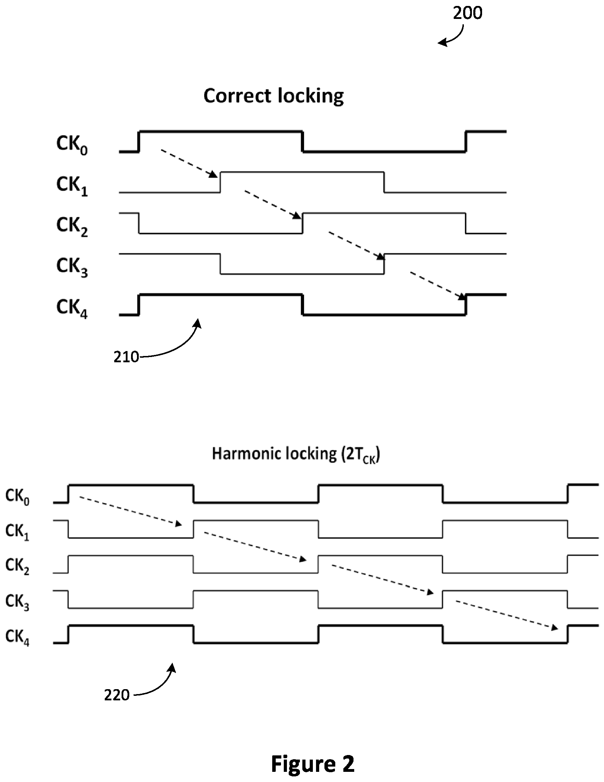

Figure 2 is a timing diagram 200 illustrating correct locking and harmonic locking conditions, in accordance with various embodiments of the subject technology. This diagram merely provides an example, which should not unduly limit the scope of the claims. One of ordinary skill in the art would recognize many variations, alternatives, and modifications.

As shown, diagram 210 illustrates an example of correct locking condition, where each intermediate clock signal (e.g., CK₁, CK₂, CK₃) propagates sequentially through the delay stages (e.g., stages 105a-d of Figure 1), and the output clock signal CK₄ achieves a desired timing relationship relative to the input clock signal CK₀. In a properly locked state, the delay applied by the delay line (e.g., circuit 101 of Figure 1) aligns the output clock signal with the phase of the input clock signal offset by one clock period (e.g., 1T_{CK}), ensuring proper timing synchronization across the system.

However, in some cases, the DLL system may enter a harmonic locking condition-as shown in diagram 220-where the delay between the input and output clock signals corresponds to a multiple of the clock period (e.g., 2T_{CK}, 3T_{CK}, etc.). Harmonic locking occurs when the delay line provides two or more complete clock cycles of delay, rather than the intended single clock cycle. As PDs and/or PFDs (e.g., detector 102) typically compare the timing relationship between CK₀ and CK₄, they are unable to distinguish between correct locking at 1T_{CK} and harmonic locking at NT_{CK} (where N ≥ 2). As a result, the DLL system may incorrectly settle into a false-locking condition, potentially impacting system timing integrity and synchronization performance.

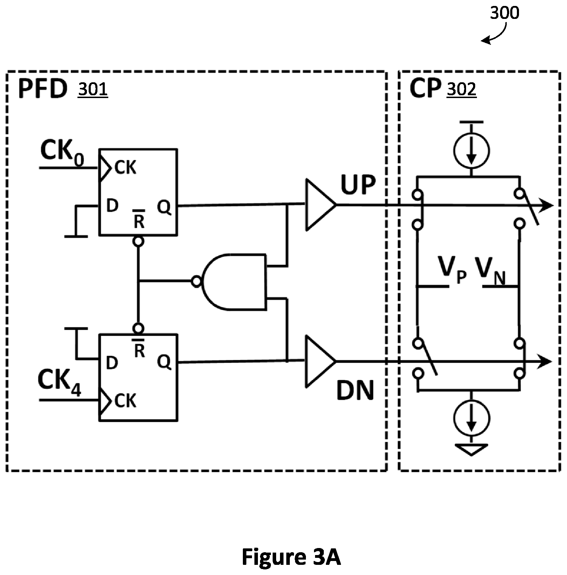

Figure 3A is a block diagram illustrating a phase detection system 300, in accordance with various embodiments of the subject technology. This diagram merely provides an example, which should not unduly limit the scope of the claims. One of ordinary skill in the art would recognize many variations, alternatives, and modifications. In various implementations, system 300 may be part of a DLL system (e.g., system 100 of Figure 1) and may be used to detect phase differences between clock signals and generate control signals to adjust delay alignment.

As shown, system 300 includes at least one of detector 301, charge pump 302, and/or the like. In some examples, detector 301 may be configured to receive an input clock signal (e.g., CK₀) and an output clock signal (e.g., CK₄) and generate phase comparison signals (e.g., UP and DN) based on the phase difference between the two clock signals. The phase comparison signals may be used to control charge pump 302, which adjusts the delay in a delay-locked loop (e.g., by modifying a control voltage (e.g., V_{CTRL}). For instance, the UP signal may be asserted when CK₀ leads CK₄, and the DN signal may be asserted when CK₀ lags CK₄. These phase comparison signals (e.g., UP and DN) dictate whether the delay line (e.g., circuit 101 of Figure 1) should increase or decrease its delay to achieve timing alignment.

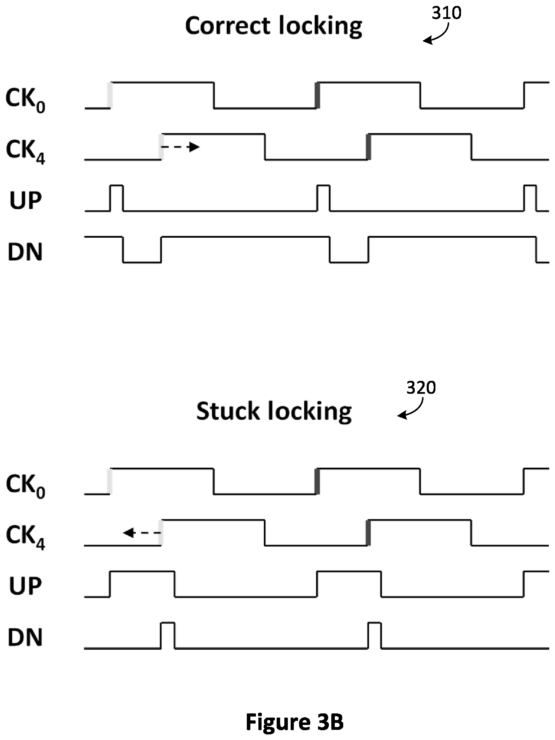

Figure 3B is a timing diagram illustrating correct locking and stuck locking conditions, in accordance with various embodiments of the subject technology. This diagram merely provides an example, which should not unduly limit the scope of the claims. One of ordinary skill in the art would recognize many variations, alternatives, and modifications. In some implementations, the timing waveforms in Figure 3B may correspond to signals generated by a phase detection system (e.g., system 300 of Figure 3A) within a DLL system (e.g., system 100 of Figure 1).

As shown, diagram 310 illustrates an example of a correct locking condition, where the output clock signal (e.g., CK₄) is phase-aligned to the input clock signal (e.g., CK₀) with a delay corresponding to one clock period (e.g., 1T_{CK}). In this condition, detector 301 compares the phase difference between CK₀ and CK₄ and generates phase comparison signals (e.g., UP and DN) to adjust the delay accordingly. As the system converges to the target phase alignment, the pulse widths of UP and DN become balanced, and the control voltage (e.g., V_{CTRL}) stabilizes, allowing the delay line (e.g., circuit 101 of Figure 1) to maintain a consistent delay corresponding to 1T_{CK}.

However, in some cases, the DLL system may enter a stuck locking condition, as shown in diagram 320. Stuck locking may occur when detector 301 (e.g., a PD) starts with a very small initial delay or when detector 301 (e.g., a PFD) begins with an incorrect internal state. In such cases, the output clock signal CK₄ may lead the input clock signal CK₀, and ideally, detector 301 should assert the DN signal to reduce the control voltage and increase the delay. However, if the UP pulse is consistently wider than the DN pulse-such as due to an initial PFD state imbalance-charge pump 302 may incorrectly drive the control voltage (e.g., V_{CTRL}) higher. As the control voltage increases, the delay line may enter its minimum delay state (e.g., minimum VCDL delay T_{VCDL}), effectively removing any further delay adjustment margin. The system then remains locked at the circuit's minimum intrinsic delay despite an existing phase misalignment, preventing convergence to the correct delay target (e.g., 1T_{CK}). This condition is referred to as stuck locking, in which the DLL loop is stuck at the lower delay boundary and is unable to correct its timing error through normal feedback operation.

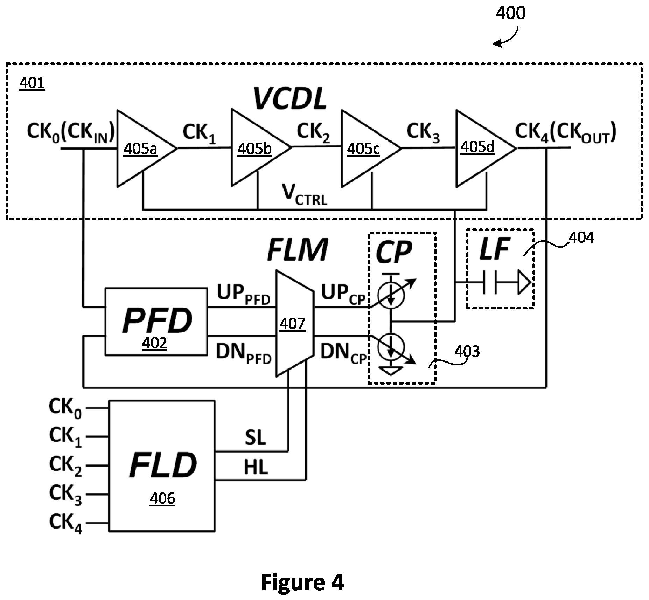

Figure 4 is a block diagram illustrating a delay-locked loop (DLL) system 400, in accordance with various embodiments of the subject technology. This diagram merely provides an example, which should not unduly limit the scope of the claims. One of ordinary skill in the art would recognize many variations, alternatives, and modifications. In various embodiments, system 400 may be configured to generate an output clock signal (e.g., CK₄) that is phase-aligned to an input clock signal (e.g., CK₀) by applying a controlled delay and adjusting the delay using a feedback control loop. As shown, system 400 includes at least one of circuit 401, first detector 402, charge pump 403, filter 404, second detector 406, controller 407, and/or the like.

In some implementations, circuit 401 may be configured to receive an input clock signal (e.g., CK₀ (CK_{IN})) and generate an output clock signal (e.g., CK₄ (CK_{OUT})) by providing a first delay to the input clock signal. For example, circuit 401 may include a voltage-controlled delay line, which may include one or more stages (e.g., stages 405a-d). Each stage may be configured to receive an intermediate clock signal and generate a delayed version of the signal for the next stage by applying a defined propagation delay. The final stage (e.g., stage 405d) may produce the output clock signal (e.g., CK₄), which is phase-shifted relative to the input clock signal CK₀ based on the cumulative delay introduced by the preceding stages.

In various examples, first detector 402 may be coupled to circuit 401 and configured to determine a phase difference between the input clock signal (e.g., CK₀) and the output clock signal (e.g., CK₄). For example, first detector 402 may include a PFD, a PD, an edge detector, a timing comparator, and/or the like. For instance, a PFD may be configured to compare both the phase and frequency of CK₀ and CK₄ and may be implemented using a pair of edge-triggered flip-flops and a reset logic gate. A PD may be configured to compare only the relative phase of CK₀ and CK₄ and may be implemented using logic gates and/or flip-flop-based edge detection circuits. As an example, first detector 402 may receive the input clock signal (e.g., CK₀) and the output clock signal (e.g., CK₄) and generate phase comparison signals (e.g., UP_{PFD} and DN_{PFD}) indicative of whether CK₄ leads or lags CK₀, thereby enabling the feedback system to correct for phase misalignment. These signals help determine the direction and magnitude of adjustment required to reduce the phase error and may then be used by downstream circuitry (e.g., charge pump 403 and filter 404) to generate a control voltage (e.g., V_{CTRL}) for adjusting the delay applied by circuit 401.

Depending on the implementation, system 400 may implement a false locking detection mechanism to improve lock accuracy and prevent convergence to incorrect timing states. For instance, the term "false locking" or "false locking condition" may refer to a state where a DLL system stabilizes at an incorrect phase alignment. Examples of false locking conditions may include, without limitation, harmonic locking, stuck locking, boundary locking, and/or the like. For example, the term "harmonic locking" or "harmonic locking condition" may refer to a condition where the delay line stabilizes at an integer multiple of the intended clock period (e.g., 2T_{CK}, 3T_{CK}, etc.) rather than at the expected T_{CK}. The term "stuck locking" or "stuck locking condition" may refer to a condition in which the delay line stabilizes at or near its minimum delay value (e.g., T_{VCDL} at V_{CTRL} = 0).

To detect false locking conditions, system 400 may include second detector 406, which may be coupled to circuit 401. Second detector 406 may be configured to monitor one or more intermediate signals within circuit 401 (e.g., CK₁ through CK₄) and determine whether the DLL is operating in a valid locking condition. For instance, the intermediate signals may provide information about the propagation distance of the input clock signal (e.g., CK₀) through the delay line. The term "propagation distance" may refer to the number of delay stages the input clock signal successfully traverses within a given clock cycle. In a valid locking condition, the propagation distance corresponds to the number of stages required to accumulate a total delay equal to one clock period (e.g., 1T_{CK}). By observing which intermediate clock signals (e.g., CK₁, CK₂, CK₃) are activated during operation, second detector 406 can determine a locking condition based on whether the signal propagation aligns with the expected delay profile (e.g., 1T_{CK}).

Based on this determination, second detector 406 may generate one or more output signals indicative of the detected locking condition. For example, second detector 406 may generate a stuck locking alarm signal (e.g., SL) when the propagation distance is below a first threshold, indicating a stuck locking condition. Similarly, it may output a harmonic locking alarm signal (e.g., HL) when the propagation distance exceeds a second threshold, indicating a harmonic locking condition. The output signals of second detector 406 may be used by downstream logic to initiate corrective measures to restore proper locking behavior.

In various embodiments, controller 407 may be coupled to first detector 402 and/or second detector 406. For example, the term "controller" may refer to a circuit or device configured to manage or direct the operation of a system or downstream components. Controller 407 may include, without limitation, a multiplexer, a finite state machine (FSM), a logic gate array, a microcontroller, and/or the like. In some implementations, controller 407 may be configured to receive phase comparison signals (e.g., UP_{PFD} and/or DN_{PFD}) from first detector 402 and false locking detection signals (e.g., SL and HL) from second detector 406 and generate one or more control signals (e.g., UP_{CP} and/or DN_{CP}) to adjust the first delay applied to the input clock signal within circuit 401. For example, the term "control signal" may refer to a signal used to enable or modify the state or operation of a functional component. For example, the adjustment of the first delay may be implemented using various techniques, including but not limited to: (i) changing a control voltage (e.g., V_{CTRL}) to vary the delay of voltage-controlled delay elements; (ii) selecting or deselecting one or more delay stages or cells in a delay line; (iii) adjusting capacitive or resistive loading on delay elements; and/or (iv) enabling or bypassing specific segments of a delay path.

As an example, when no false locking condition is detected (e.g., both SL and HL are deasserted), controller 407 may pass through the UP_{PFD} and/or DN_{PFD} signals to charge pump 403 for normal phase alignment control. However, when either SL or HL is asserted, controller 407 may override the phase comparison signals and generate forced control signals (e.g., UP_{CP} and/or DN_{CP}) to drive the delay line out of the false locking region.

In some embodiments, charge pump 403 may be coupled to controller 407 and configured to generate a control voltage (e.g., V_{CTRL}) based on the control signals (e.g., UP_{CP} and/or DN_{CP}). For instance, when an UP signal is asserted, charge pump 403 may increase V_{CTRL} to reduce the first delay; when a DN signal is asserted, charge pump 403 may decrease V_{CTRL} to increase the first delay. In some cases, filter 404 may be coupled to charge pump 403 and configured to filter the output signal generated by charge pump 403, thereby producing a stable control voltage for tuning circuit 401.

It is to be appreciated that the incorporation of false locking detection and correction mechanisms enables system 400 to achieve robust phase-locking behavior across a wide range of operating conditions. By actively monitoring both the input-output phase relationship and the internal propagation of the clock signal within the delay line, system 400 can detect and recover from false locking conditions without requiring manual intervention or delay calibration. Moreover, the ability of controller 407 to selectively override phase comparison signals based on the real-time locking condition enhances lock robustness and avoids performance degradation due to false convergence.

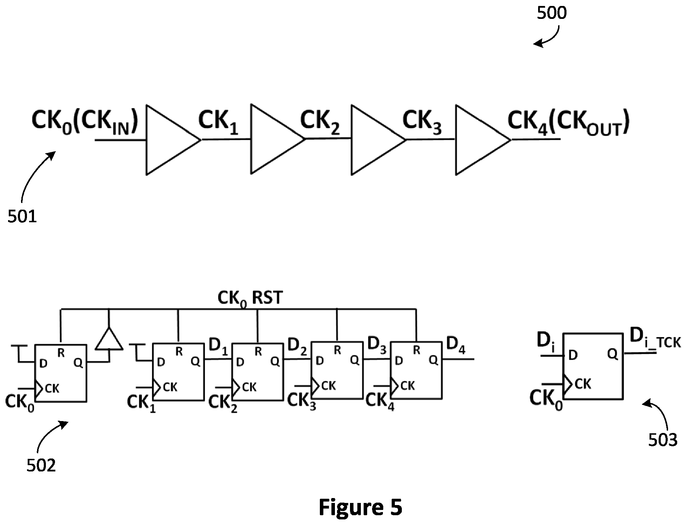

Figure 5 is a circuit diagram illustrating a false-locking detector (FLD) 500, in accordance with various embodiments of the subject technology. This diagram merely provides an example, which should not unduly limit the scope of the claims. One of ordinary skill in the art would recognize many variations, alternatives, and modifications. In various implementations, detector 500 may be part of a DLL system (e.g., system 400 of Figure 4) and configured to detect false locking conditions (e.g., stuck locking or harmonic locking). For instance, detector 500 may correspond to second detector 406 of Figure 4 and may be configured to determine the propagation distance of the input clock signal (e.g., CK₀) through delay line 501 over a defined time window (e.g., 1T_{CK}).

As shown, delay line 501 may include one or more stages configured to generate intermediate clock signals (e.g., CK₁ through CK₄) by sequentially delaying the input clock signal (e.g., CK₀). For example, delay line 501 may correspond to circuit 401 of Figure 4 and may be implemented using buffers, inverters, and/or other propagation delay elements. Each intermediate clock signal (e.g., CK₁- CK₄) may represent the propagated version of the input clock signal after passing through a corresponding number of delay stages.

According to some embodiments, detector 500 may include sampling circuit 502, which may be configured to sample propagation of the input clock signal (e.g., CK₀) within delay line 501 and provide a first signal indicative of a propagation distance of the input clock signal. For instance, the term "sampling circuit" may refer to a circuit or device configured to observe and capture the state or timing of one or more signals at defined sampling instants, such as clock edges or trigger events. Examples of sampling circuits may include, without limitation, flip-flop arrays, latch chains, sample-and-hold circuits, edge-triggered comparators, and/or the like. As used herein, the term "sample" refers broadly to the act of observing, capturing, detecting, or recording the value, timing, or presence of a signal (e.g., an intermediate clock edge or voltage transition) at a specific point in time, such as a clock edge or trigger event. The sampled information may represent timing relationships, logical states, or voltage levels, and may be stored temporarily or processed immediately for further analysis. As used herein, "indicative of" means that the signal conveys, represents, or encodes information related to how far the input clock signal has propagated within the delay line. For example, the first signal may include a thermometer code, a gray code, or a binary value indicating how many sampling points have detected a clock edge. In some cases, the signal may be a pulse, vector, or digital word that reflects the number of activated latches or sampling stages. Other non-limiting examples may include time-stamped edge detection, leading edge position encoding, or analog voltage levels corresponding to signal reach.

Depending on the implementation, sampling circuit 502 may include one or more sampling elements configured to detect the timing or state of intermediate signals derived from the input clock signal. For instance, the term "sampling element" may refer to a device or component capable of capturing and storing a signal value at a defined sampling event. Examples of sampling elements may include, without limitation, flip-flops, edge-triggered registers, latches, memory elements, and/or the like.

In some examples, sampling circuit 502 may include a chain of flip-flops clocked by intermediate signals CK₁ through CK₄. In operation, these flip-flops may be reset to logic "0" at every rising edge of CK₀ using a reset signal (e.g., CK_{0_RST}) and configured to propagate a logic "1" along the delay path in synchronization with the delayed clock edges. In some cases, the sampled values D₁-D₄ are thus updated to reflect the number of stages the input clock edge successfully traverses during a single clock period (e.g., 1T_{CK}), providing a thermometer-coded representation of the propagation distance.

In some embodiments, detector 500 further includes an encoder 503 configured to sample and evaluate the outputs D₁ through D₄ at the next rising edge of CK₀. The encoder may be configured to convert the thermometer-coded values into a digital representation of the number of stages traversed by the clock edge within one clock cycle. For instance, encoder 503 may detect the location k at which D_{k_TCK}⊕D_{k+1_TCK} = 1, which indicates the transition point in the thermometer code and thus identifies the propagation depth N_{TCK}. This value serves as a metric for determining whether the DLL is correctly locked (e.g., N_{TCK} = 4) or in a false locking condition (e.g., N_{TCK} > 4 for stuck locking or N_{TCK} < 4 for harmonic locking). The encoded result may be forwarded to logic that generates the SL and HL signals (e.g., by second detector 406 in Figure 4) for use in correcting the locking behavior.

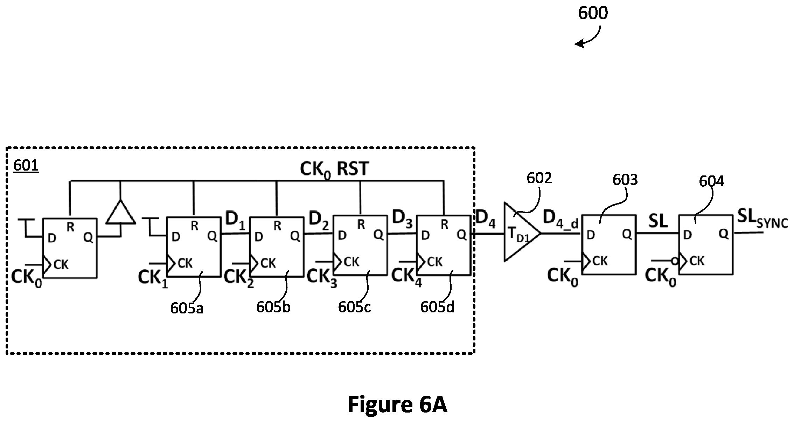

Figure 6A is a circuit diagram illustrating a false-locking detector (FLD) 600 for detecting stuck locking, in accordance with various embodiments of the subject technology. This diagram merely provides an example, which should not unduly limit the scope of the claims. One of ordinary skill in the art would recognize many variations, alternatives, and modifications. In some implementations, detector 600 may be part of a DLL system (e.g., system 400 of Figure 4) and used to determine whether the delay line is operating in a stuck locking condition-e.g., when the total delay of the line is insufficient to produce a full clock period delay and the system becomes locked at or near the minimum delay value (e.g., T_{VCDL}).

As shown, detector 600 may include sampling circuit 601, which may be configured to sample propagation of the input clock signal (e.g., CK₀) within a delay line and provide a signal indicative of a propagation distance of the input clock signal. For example, sampling circuit 601 may include a chain of stages (e.g., stages 605a-d) clocked by intermediate signals CK₁ through CK₄. In operation, these flip-flops may be reset to logic "0" at every rising edge of CK₀ using a reset signal (e.g., CK_{0_RST}) and configured to propagate a logic "1" along the delay path in synchronization with the delayed clock edges. In some cases, the sampled values D₁-D₄ are thus updated to reflect the number of stages the input clock edge successfully traverses during a single clock period (e.g., 1T_{CK}), providing a thermometer-coded representation of the propagation distance.

In order to detect a stuck locking condition, the output of the final stage (e.g., D₄) may be passed to stage 602, which may be configured to produce a delayed version of D₄ (e.g., D_{4_d}) by applying a third delay (e.g., T_{D1}) to D₄. For instance, the third delay may be used to compensate for timing skew and ensure robust detection near the boundary of the 1T_{CK} timing window. Depending on the implementation, the third delay (e.g., T_{D1}) may be programmable, fixed, adjustable, and/or the like.

In some implementations, stage 603 may be coupled to stage 602 and configured to capture the value of D_{4_d} at the next rising edge of CK₀. As an example, if D_{4_d} is sampled as high at this time, it implies that the logic "1" has propagated through all four stages of the delay line plus the third delay (e.g., T_{D1}) within a single clock cycle (e.g., 1T_{CK}). This indicates that the instantaneous delay of the delay line (e.g., T_{VCDL}) is so short that the signal completes full propagation before the end of one clock cycle (e.g., T_{VCDL} ≥ T_{CK} - T_{D1}), indicating a stuck locking condition. In such a case, stage 603 may assert a third signal (e.g., a stuck locking alarm signal (SL)) indicating that the system may be in a stuck locking condition.

In various embodiments, the third signal (e.g., SL) may be passed to stage 604, which may be coupled to stage 603 and include one or more flip-flops clocked by CK₀. For instance, stage 604 may be configured to filter glitches and register SL into a synchronized form (e.g., SL_{SYNC}), which may be provided to downstream control logic (e.g., controller 407 of Figure 4) to trigger corrective action. In some cases, assertion of SL_{SYNC} may cause override control signals (e.g., DN_{CP}) to be applied, increasing the delay and forcing the DLL out of the stuck locking condition.

It is to be appreciated that detector 600 provides a reliable mechanism for identifying premature locking behavior in DLL systems. By ensuring that the rising edge of CK₀ samples the delayed output of the final stage (e.g., D_{4_d}), the detection mechanism provides a robust lower bound on the minimum allowable delay. The use of a small, fixed offset delay (e.g., T_{D1}) and thermometer-coded propagation allows detection sensitivity to be finely tuned, ensuring reliable detection without requiring complex timing calibration. Additionally, the pulse width of the reset signal (e.g., CK_{0_RST}) can be easily designed to be shorter than the arrival time of CK₁, thereby ensuring proper reset behavior before signal propagation begins.

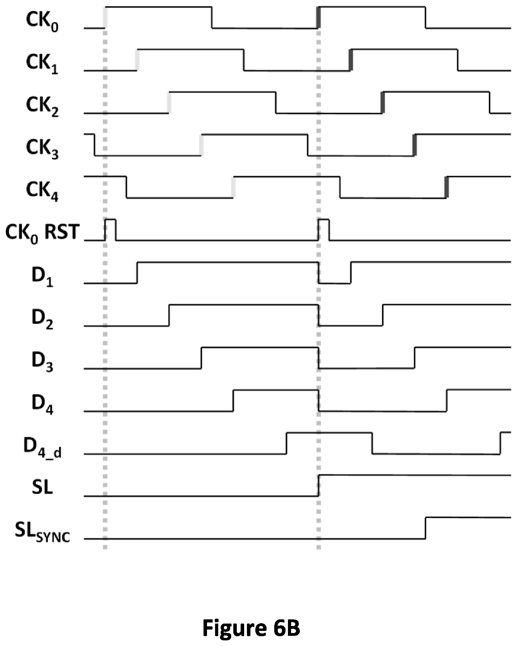

Figure 6B is a timing diagram illustrating a stuck locking condition, in accordance with various embodiments of the subject technology. This diagram merely provides an example, which should not unduly limit the scope of the claims. One of ordinary skill in the art would recognize many variations, alternatives, and modifications. In some implementations, the waveforms shown in Figure 6B may correspond to signals generated by a false-locking detector (e.g., detector 600 of Figure 6A). As shown, the input clock signal CK₀ propagates through a series of delay stages, producing intermediate signals CK₁ through CK₄. These signals may represent progressively delayed versions of CK₀, each associated with a corresponding delay stage (e.g., stages 105a-d of Figure 1) in the delay line.

At each rising edge of CK₀, a reset signal CK₀_RST may be asserted briefly to reset the internal flip-flops that store the sampled propagation data (e.g., D₁ through D₄). After the reset, a logic "1" begins propagating along the sampling chain, where each intermediate signal (e.g., CK₁ through CK₄) clocks its corresponding flip-flop to latch the propagating value. As shown in Figure 6B, the values D₁ through D₄ successively transition high within one clock period (e.g., 1T_{CK}), generating a thermometer-coded representation of the propagation distance.

At the end of the delay chain, D₄ may be passed through an additional delay stage (e.g., stage 602 of Figure 6A) to produce D_{4_d}. At the next rising edge of CK₀, D_{4_d} may be sampled by stage 603 to generate the SL signal in response to D_{4_d} being high when captured. The assertion of SL indicates that the logic "1" propagated across all delay stages, including the additional delay (e.g., T_{D1}) within one clock cycle, thus suggesting a stuck locking condition. To ensure robustness and synchronization with system logic, the SL signal may be passed through stage 604 to generate the SL_{SYNC} signal, which may serve as a synchronized alarm output indicating that the DLL system has entered a stuck locking condition. The SL_{SYNC} signal may be provided to downstream control logic (e.g., controller 407 of Figure 4) to trigger corrective action. In some cases, assertion of SL_{SYNC} may cause override control signals (e.g., DN_{CP}) to be applied, increasing the delay and forcing the DLL out of the stuck locking condition.

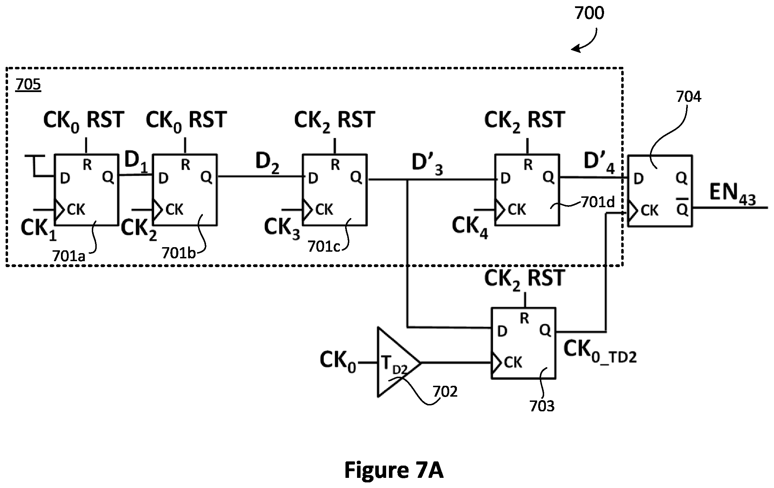

Figures 7A-7B are circuit diagrams illustrating a false-locking detector (FLD) 700 for detecting harmonic locking, in accordance with various embodiments of the subject technology. These diagrams merely provide an example, which should not unduly limit the scope of the claims. One of ordinary skill in the art would recognize many variations, alternatives, and modifications. In some implementations, detector 700 may be part of a DLL system (e.g., system 400 of Figure 4) and used to determine whether the delay line is operating in a harmonic locking condition-e.g., where the delay line produces a total delay corresponding to an integer multiple of the clock period (e.g., 2T_{CK}, 3T_{CK}, etc.), rather than the intended single period (e.g., 1T_{CK}).

As shown in Figure 7A, detector 700 may include sampling circuit 705, which may be configured to sample propagation of the input clock signal (e.g., CK₀) within a delay line and provide a signal indicative of a propagation distance of the input clock signal. For example, sampling circuit 701 may include a chain of stages (e.g., stages 701a-d) clocked by intermediate signals CK₁ through CK₄. In operation, stages 701a-d may be reset to logic "0" at every rising edge of CK₀ using a reset signal (e.g., CK₀_RST) and configured to propagate a logic "1" along the delay path in synchronization with the delayed clock edges. In some cases, the sampled values D₁-D₄ may be updated to reflect the number of stages the input clock edge successfully traverses during a single clock period (e.g., 1T_{CK}), providing a thermometer-coded representation of the propagation distance.

In order to detect harmonic locking, the outputs of stages 701c and 701d (e.g., D₃ and D₄) may be passed to additional sampling stages to produce delayed versions of these outputs (e.g., D'₃ and D'₄). For instance, stages 701c and 701d may be reset by a reset signal (e.g., CK₂_RST), which may be asserted at the rising edge of CK₂. The resetting operation ensures that any residual values at D'₃ and D'₄ are cleared before the arrival of subsequent clock edges at CK₃ and CK₄, thereby avoiding race conditions and minimizing metastability risks near the critical timing window at the later stages of the delay line.

In some implementations, detector 700 may further include stage 702, which may be configured to receive the input clock signal (e.g., CK₀) and generate a delayed version of CK₀ (e.g., CK_{0_TD2}) by applying a fourth delay (e.g., T_{D2}) to CK₀. For instance, the fourth delay (e.g., T_{D2}) may be used to provide a reference point for edge comparison, and may be implemented using a buffer chain, delay element, programmable delay line, and/or the like. Depending on the implementation, the fourth delay (e.g., T_{D2}) may be programmable, fixed, adjustable, and/or the like.

In some implementations, stage 703 may be coupled to stage 702 and configured to sample the value of D'₃ at the rising edge of CK_{0_TD2}. The output of stage 703 (e.g., CK_{0_TD2}) provides an indication of whether a clock edge has propagated through the third delay stage (e.g., stage 701c) before a predefined timing threshold.

In various examples, detector 700 may include stage 704, which may be coupled to stage 703 and/or stage 701d. For instance, stage 704 may be configured to receive an output signal from stage 703 (e.g., CK_{0_TD2}) and an output signal from stage 701d (e.g., D'₄) and generate a harmonic locking enable signal (e.g., EN₄₃). In some cases, stage 704 may include combinational logic (e.g., logic gates, flip-flops, and/or other logic circuits) configured to detect a specific timing relationship between the sampled propagation signals.

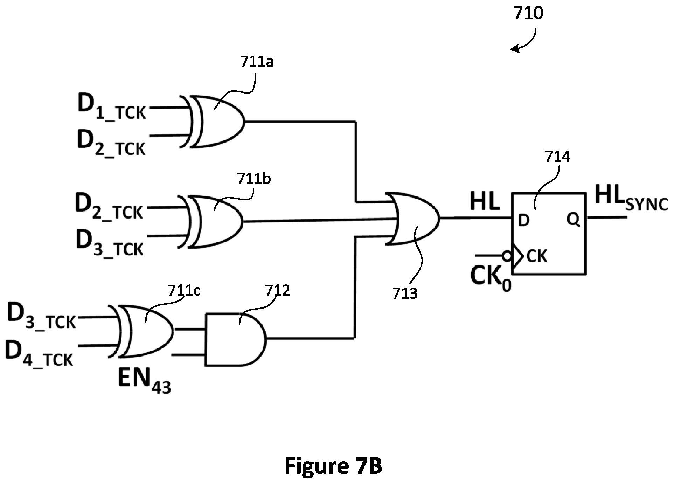

Figure 7B is a circuit diagram illustrating a harmonic locking detection logic 710, which may be used in conjunction with detector 700 of Figure 7A for generating a harmonic locking alarm signal (e.g., HL) and/or a synchronized alarm signal (e.g., HL_{SYNC}), in accordance with various embodiments of the subject technology. This diagram merely provides an example, which should not unduly limit the scope of the claims. One of ordinary skill in the art would recognize many variations, alternatives, and modifications.

In various implementations, detection logic 710 may include one or more logic gates (e.g., logic gates 711a-c) configured to evaluate sampled propagation data (e.g., D_{1_TCK}, D_{2_TCK}, D_{3_TCK}, D_{4_TCK}, etc.) and the harmonic locking enable signal (e.g., EN₄₃) generated by detector 700 of Figure 7A. For instance, the term "logic gate" may refer to an electronic component or circuit configured to perform a certain logical operation on one or more input signals to generate an output signal. Examples of logic gates may include, without limitation, AND gates, OR gates, XOR gates, NAND gates, NOR gates, and/or the like. In some cases, logic gates may be implemented using discrete transistors, standard cell library components, programmable logic devices, field-programmable gate arrays (FPGAs), and/or the like.

As an example, logic gate 711a may be implemented as an XOR gate and configured to receive D_{1_TCK} and D_{2_TCK} as input signals. The output of logic gate 711a may be high (e.g., logic "1") when the sampled values of D_{1_TCK} and D_{2_TCK} differ-indicating that a clock edge transition occurred between stage 701a and stage 701b of Figure 7A-which corresponds to a propagation distance of one delay stage (e.g., N_{TCK} = 1). In some embodiments, logic gate 711b may also be implemented as an XOR gate and configured to receive D_{2_TCK} and D_{3_TCK}. The output of logic gate 711b may indicate whether a clock edge transition occurred between stage 701b and stage 701c of Figure 7A, corresponding to a propagation distance of two delay stages (e.g., N_{TCK} = 2). The outputs of logic gates 711a and 711b may be combined by logic gate 713 to assert an HL signal if either condition is true. It is to be appreciated that detection of either transition corresponds to a harmonic locking condition where the input clock signal (e.g., CK₀) has propagated only through the first or second delay stage (e.g., stage 701a and/or 701b) within one clock period (e.g., 1T_{CK}), resulting in a first type of harmonic locking condition (e.g., N_{TCK} = 1, 2).

In various examples, logic gate 711c may be implemented as an XOR gate and configured to receive D_{3_TCK} and D_{4_TCK}. The output of logic gate 711c may detect a clock edge transition between stage 701c and stage 701d of Figure 7A (e.g., N_{TCK} = 3). In some cases, the output of logic gate 711c may be coupled to logic gate 712, which may be implemented as an AND gate. Logic gate 712 may also receive the harmonic locking enable signal (e.g., EN₄₃) from stage 704 of Figure 7A. For instance, EN₄₃ may be asserted when a rising edge at CK₄ leads the next rising edge of CK₀ by more than a predefined timing margin (e.g., T_{D2}). Logic gate 712 may be configured to assert an output signal when both conditions are satisfied, indicating a second type of harmonic locking condition where the input clock signal has propagated through the third delay stage (e.g., stage 701c) within one clock period (e.g., N_{TCK} = 3) but not through the fourth delay stage (e.g., stage 701d) within one clock period plus the predefined timing margin (e.g., N_{TCK+TD2} = 3).

In some implementations, logic gate 713 may be implemented as an OR gate and configured to logically combine the outputs of logic gates 711a-b and 712. For instance, if either of logic gates 711a or 711b asserts a signal (e.g., indicating a detected transition between D_{1_TCK} and D_{2_TcK} or between D_{2_TCK} and D_{3_TCK}, corresponding to N_{TCK} = 1 or N_{TCK} = 2), or if logic gate 712 asserts a signal (e.g., indicating a transition between D_{3_TCK} and D_{4_TCK} with EN₄₃ asserted, corresponding to N_{TCK} = 3 & N_{TCK+TD2} = 3), then logic gate 713 may assert the harmonic locking alarm signal (e.g., HL). The HL signal may indicate that the DLL system has entered a harmonic locking condition, where the total delay applied by the delay line corresponds to an unintended multiple of the clock period (e.g., 2T_{CK}, 3T_{CK}, etc.) instead of the expected single period (e.g., 1T_{CK}).

In various embodiments, logic gate 713 may be coupled to stage 714, which may be implemented as a flip-flop or latch circuit clocked by CK₀. For example, stage 714 may be configured to register and synchronize the HL signal, producing a stable output signal (e.g., HL_{SYNC}) that can be provided to downstream control logic (e.g., controller 407 of Figure 4). The assertion of HL_{SYNC} may trigger corrective action by the DLL system to drive the delay line out of the false locking state and restore correct phase alignment.

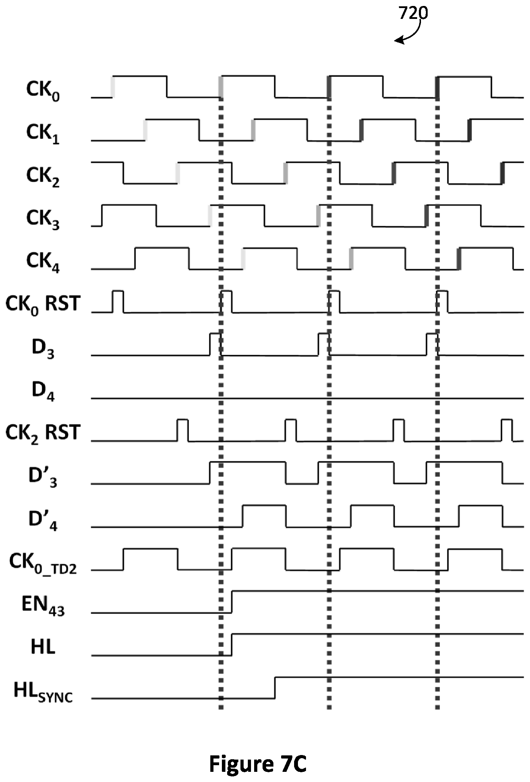

Figure 7C is a timing diagram illustrating a second type of harmonic locking condition 720, in accordance with various embodiments of the subject technology. This diagram merely provides an example, which should not unduly limit the scope of the claims. One of ordinary skill in the art would recognize many variations, alternatives, and modifications. In some implementations, the waveforms shown in Figure 7C may correspond to signals generated by a false-locking detector (e.g., detector 700 of Figure 7A) and a harmonic locking detection logic (e.g., detection logic 710 of Figure 7B).

As shown, the input clock signal CK₀ propagates through the delay stages of the delay line, producing intermediate clock signals CK₁ through CK₄. These signals may represent progressively delayed versions of CK₀, each associated with a corresponding stage of the delay line (e.g., stages 701a-d of Figure 7A). At each rising edge of CK₀, a reset signal CK_{0_}RST may be asserted briefly to reset the internal flip-flops that store sampled propagation data (e.g., D₁ through D₄). Following the reset, the logic "1" is propagated through the sampling chain by the delayed clock signals.

Depending on the implementation, the outputs of stages 701c and 701d (e.g., D₃ and D₄) may be subsequently sampled by additional stages to produce delayed versions (e.g., D'₃ and D'₄). The CK₂_RST signal may also be generated to reset these sampling stages at the rising edge of CK₂ to ensure proper timing operation and prevent race conditions. In some cases, the input clock signal CK₀ may be delayed by a fixed or programmable amount (e.g., T_{D2}) to produce CK_{0_TD2}. The state of D'₃ is then sampled at the rising edge of CK_{0_TD2}, and if D'₃ remains high, this indicates that a clock edge reached only the third delay stage (e.g., stage 701c) within both one clock period and one clock period plus the predefined timing margin. This condition determines the assertion of EN₄₃, which acts as an enable signal for detecting a second type of harmonic locking condition.

Detection logic 710 of Figure 7B may then analyze the sampled signals D_{1_TCK} through D_{4_TCK} and EN₄₃ to determine whether a harmonic locking condition has occurred. As an example, HL is asserted if either: (i) a transition is detected between D_{1_TCK} and D_{2_TCK} or between D_{2_TCK} and D_{3_TCK} (e.g., corresponding to N_{TCK} = 1 or 2), or (ii) a transition is detected between D_{3_TCK} and D_{4_TCK} with EN₄₃ asserted (e.g., corresponding to N_{TCK} = 3 & N_{TCK+TD2} = 3).

Once HL is asserted, stage 714 may register the HL signal at the next rising edge of CK₀, generating a stable synchronized output HL_{SYNC}. In some cases, HL_{SYNC} remains high across multiple clock cycles, providing a reliable alarm signal to downstream control logic (e.g., controller 407 of Figure 4) to trigger corrective action. This may include overriding normal phase control to force the delay line out of the false locked state and resume normal phase alignment operation.

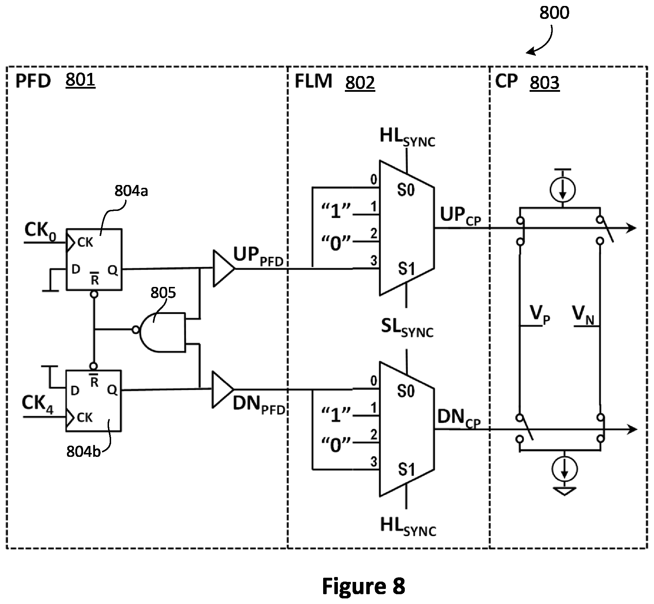

Figure 8 is a block diagram illustrating a delay-locked loop (DLL) system 800, in accordance with various embodiments of the subject technology. This diagram merely provides an example, which should not unduly limit the scope of the claims. One of ordinary skill in the art would recognize many variations, alternatives, and modifications. In some implementations, system 800 may be part of a DLL system (e.g., system 400 of Figure 4) and configured to detect and correct false locking conditions (e.g., stuck locking or harmonic locking) within a DLL by modifying control signals to a charge pump in response to detected phase anomalies.

As shown, system 800 may include at least first detector 801, controller 802, charge pump (CP) 803, and/or the like. In some examples, first detector 801 may include a PFD configured to receive an input clock signal (e.g., CK₀) and an output clock signal (e.g., CK₄) generated by a delay line (e.g., first circuit 401 of Figure 4) and generate phase comparison signals (e.g., UP_{PFD} and DN_{PFD}) indicative of whether the output clock signal (e.g., CK₄) leads or lags the input clock signal (e.g., CK₀). For instance, the PFD may be implemented using a pair of flip-flops 804a-b and a logic gate 805 to compare both the phase and frequency of CK₀ and CK₄, thereby enabling system 800 to determine the phase relationship and direction of adjustment needed to align the two clock signals.

In various embodiments, controller 802 may be implemented as a false locking multiplexer (FLM). The FLM may be configured to receive the phase comparison signals (e.g., UP_{PFD} and/or DN_{PFD}) from first detector 801 and false locking detection signals (e.g., SL_{SYNC} and/or HL_{SYNC}) from a false-locking detector (e.g., detector 600 of Figure 6A or detector 700 of Figure 7A). For example, SL_{SYNC} may indicate detection of a stuck locking condition, and HL_{SYNC} may indicate detection of a harmonic locking condition.

In some implementations, controller 802 may be configured to generate one or more control signals (e.g., UP_{CP} and/or DN_{CP}) based on the detected locking state of the DLL system to adjust the delay applied to the input clock signal (e.g., CK₀) within the delay line. In one example, when both SL_{SYNC} and HL_{SYNC} are deasserted (e.g., logic "0"), indicating no false locking condition is detected, controller 802 may pass the phase comparison signals (e.g., UP_{PFD} and/or DN_{PFD}) from first detector 801 directly to charge pump 803 (e.g., UP_{CP} = UP_{PFD}, DN_{CP} = DN_{PFD}), allowing the DLL to operate in normal feedback mode.

When SL_{SYNC} is asserted and HL_{SYNC} is deasserted (e.g., SL_{SYNC} = 1, HL_{SYNC} = 0), indicating detection of a stuck locking condition, controller 802 may override the phase comparison signals and force UP_{CP} = 0 and DN_{CP} = 1 to drive the delay line to a slower state. When SL_{SYNC} is deasserted and HL_{SYNC} is asserted (e.g., SL_{SYNC} = 0, HL_{SYNC} = 1), indicating detection of a harmonic locking condition, controller 802 may override the phase comparison signals and force UP_{CP} = 1 and DN_{CP} = 0 to drive the delay line to a faster state. In a rare condition where both SL_{SYNC} and HL_{SYNC} are asserted (e.g., logic "1"), controller 802 may default to a transparent mode and pass the phase comparison signals directly to charge pump 803.

In some embodiments, charge pump 803 may be coupled to controller 802 and configured to generate a control voltage based on the received control signals (e.g., UP_{CP} and/or DN_{CP}). For instance, when an UP_{CP} signal is asserted, charge pump 803 may increase the control voltage to reduce the delay applied to the input clock signal (e.g., CK₀); when a DN_{CP} signal is asserted, charge pump 403 may decrease the control voltage to increase the delay. In some examples, charge pump 803 may source or sink current to adjust the control voltage depending on whether an UP_{CP} or DN_{CP} signal is active. The control voltage may be applied to a delay line (e.g., circuit 401 of Figure 4) to adjust the total delay applied to the input clock signal (e.g., CK₀) and align it with the output clock signal (e.g., CK₄). In some cases, charge pump 803 may include additional voltage references (e.g., V_{P}, V_{N}) to set current source and sink levels for stable operation.

It is to be appreciated that the incorporation of controller 802 allows system 800 to selectively override phase comparison signals (e.g., UP_{PFD} and DN_{PFD}) when false locking conditions are detected, providing a robust mechanism to prevent and recover from false convergence. By actively monitoring both phase difference and internal propagation signals (e.g., via SL_{SYNC} and HL_{SYNC}), system 800 enhances locking accuracy and stability across wide operating conditions, improving overall DLL performance and reducing the need for manual tuning or calibration.

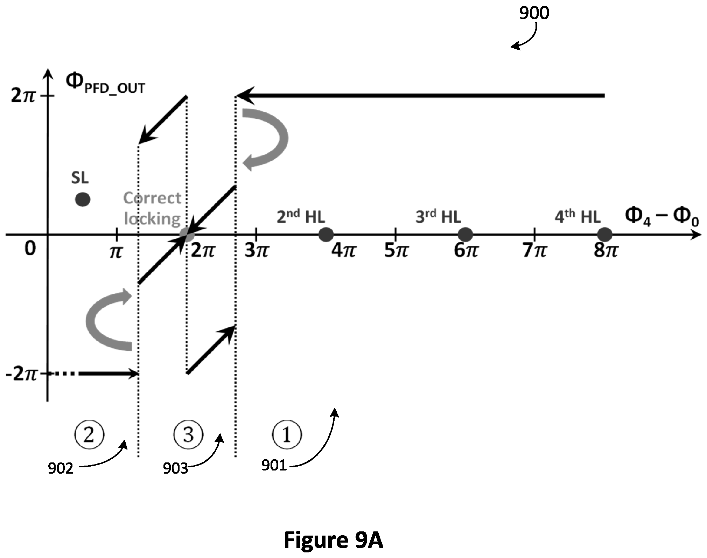

Figure 9A is a graph illustrating the transfer curve 900 of a false-locking-detector-assisted PFD inside a delay-locked loop (DLL) system with annotated correct locking and false locking points, in accordance with various embodiments of the subject technology. This diagram merely provides an example, which should not unduly limit the scope of the claims. One of ordinary skill in the art would recognize many variations, alternatives, and modifications.

In various embodiments, transfer curve 900 illustrates the relationship between PFD (e.g., first detector) output (e.g., Φ_{PFD_OUT}) and input (e.g. (Φ₄ - Φ₀)), which is the phase difference between the DLL output clock signal (e.g., CK₄) and the input clock signal (e.g., CK₀). In some embodiments, the system may define three regions of operation based on the real-time locking condition. For instance, first region 901 may correspond to a harmonic locking detection zone, where the total delay of the delay line exceeds a predefined upper threshold (e.g., T_{VCDL} ≥ T_{CK} + T_{D2}). Without the controller (e.g., controller 407 of Figure 4 or controller 802 of Figure 8), the DLL system may falsely stabilize at a false-locking point (e.g., Φ₄-Φ₀=4π at 2^{nd} HL, Φ₄-Φ₀=6π at 3^{rd} HL) corresponding to an integer multiple of the intended clock period, as Φ_{PFD_OUT} stays at 0, the same as Φ_{PFD_OUT} value of the correct locking point. To prevent the system from remaining trapped in a harmonic locking state, the controller (e.g., controller 407 of Figure 4 or controller 802 of Figure 8) may force an always-on control condition of UP_{CP} = 1 and DN_{CP} = 0, such that Φ_{PFD_OUT} equals 2π in this zone, to decrease the delay until the system is back toward the correct locking zone.

In some examples, second region 902 may correspond to a stuck locking detection zone, where the total delay of the delay line is less than a predefined lower threshold (e.g., T_{VCDL} ≤ T_{CK} - T_{D1}). Without the controller (e.g., controller 407 of Figure 4 or controller 802 of Figure 8), since Φ_{PFD_OUT} is positive, the DLL system tries to decrease the delay to the point Φ₄-Φ₀=0 at origin, which can never be reached due to circuit's intrinsic delay. It may lead to a stuck condition where CK₄ exhibits a very small phase shift relative to CK₀. To drive the system out of this condition, the controller may assert a forced always-on control state of UP_{CP} = 0 and DN_{CP} = 1, such that Φ_{PFD_OUT} is a negative number -2π in this zone, to increase, rather than to decrease, the delay until the system is back toward the correct locking zone.

In various examples, third region 903 may correspond to a correct locking zone, where the total delay of the delay line falls within acceptable operating limits (e.g., T_{CK} - T_{D1} ≤ T_{VCDL} ≤ T_{CK} + T_{D2}). In this condition, the DLL system is considered correctly locked, and the controller may allow the phase detector feedback (e.g., UP_{PFD} and DN_{PFD}) to directly control the delay line. This region represents the normal operating state where the DLL dynamically adjusts the delay to maintain desired phase alignment between CK₄ and CK₀ without forced intervention.

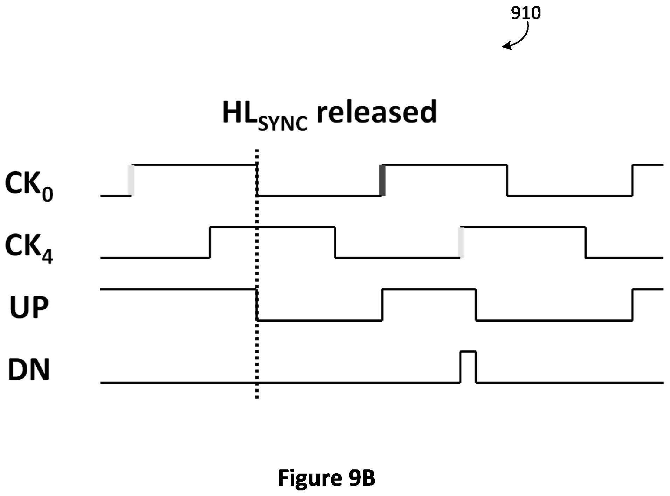

Figure 9B is a timing diagram 910 illustrating an example of leaving harmonic locking for correct locking, in accordance with various embodiments of the subject technology. This diagram merely provides an example, which should not unduly limit the scope of the claims. One of ordinary skill in the art would recognize many variations, alternatives, and modifications. As shown, when the DLL system enters a harmonic locking condition (e.g., operation within first region 901 of Figure 9A), the output clock signal (e.g., CK₄) leads the input clock signal (e.g., CK₀) by more than an allowed timing margin (e.g., T_{D2}). The false-locking detector (e.g., second detector 406 of Figure 4 or detector 700 of Figure 7A) may identify this abnormal lead condition and assert the harmonic locking alarm signal (e.g., HL_{SYNC}). Upon release of HL_{SYNC}, the controller (e.g., controller 407 of Figure 4 or controller 802 of Figure 8) stops overriding the normal phase detector output at the next falling edge of CK₀. CK₄ phase slightly lags CK₀ phase when the DLL just leaves out of the harmonic locking condition. The transition toward the correct locking zone (e.g., third region 903 of Figure 9A) may resume with normal phase alignment control.

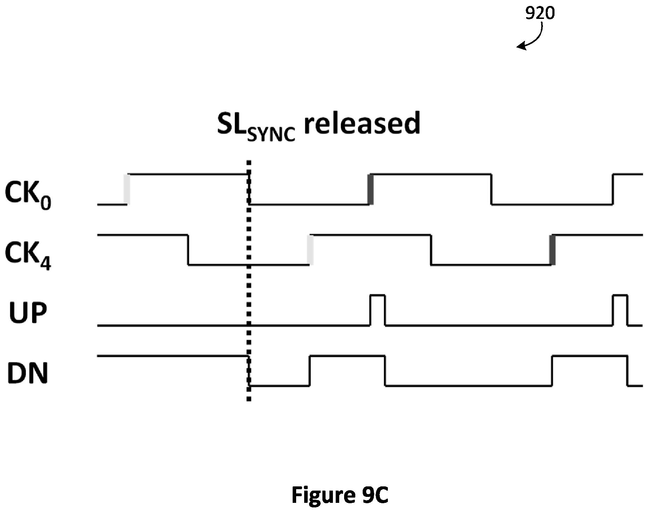

Figure 9C is a timing diagram 920 illustrating an example of leaving stuck locking for correct locking, in accordance with various embodiments of the subject technology. This diagram merely provides an example, which should not unduly limit the scope of the claims. One of ordinary skill in the art would recognize many variations, alternatives, and modifications. As shown, when the DLL system enters a stuck locking condition (e.g., operation within second region 902 of Figure 9A), the output clock signal (e.g., CK₄) exhibits minimal or near-zero phase shift relative to the input clock signal (e.g., CK₀). This may occur when the delay line stabilizes prematurely at or near its minimum delay value (e.g., T_{VCDL}). In response to this condition, the false-locking detector (e.g., second detector 406 of Figure 4 or detector 600 of Figure 6A) may determine that the clock edge propagation distance falls below a predefined threshold and assert the stuck locking alarm signal (e.g., SL_{SYNC}). Upon release of SL_{SYNC}, the controller (e.g., controller 407 of Figure 4 or controller 802 of Figure 8) stops overriding the normal phase detector outputs at the next falling edge of CK₀. CK₄ phase slightly leads CK₀ phase when the DLL just leaves out of the stuck locking condition. The transition toward the correct locking zone (e.g., third region 903 of Figure 9A) may resume with normal phase alignment control.

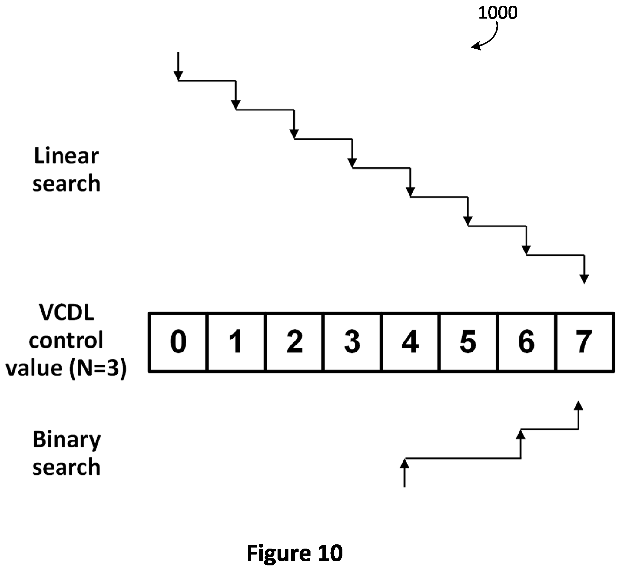

Figure 10 is a diagram 1000 illustrating a comparison of two calibration methods of searching for the correct fixed delay code, in accordance with various embodiments of the subject technology. This diagram merely provides an example, which should not unduly limit the scope of the claims. One of ordinary skill in the art would recognize many variations, alternatives, and modifications.

In some implementations, calibration may be performed to ensure that the voltage-controlled delay line covers the required delay range. For example, in certain applications (e.g., frequency divider), the DLL system may be required to accommodate up to a 2× delay range, which cannot be fully covered by varying the V_{CTRL} voltage alone. Therefore, additional fixed delay code-such as coarse delay settings (e.g., selection of the number of delay cells, delay cell C_{LOAD} adjustment)-may be provided to extend the delay range coverage.

During calibration mode, since the required delay is already known, the corresponding fixed delay code may be found. The DLL feedback loop may be broken, and the VCDL control bits may be preset to a center value. The phase detector (e.g., first detector 402 of Figure 4 or detector 801 of Figure 8) may evaluate whether the VCDL delay (e.g., T_{VCDL}) at the current fixed delay code is greater than or less than the target clock period (e.g., 1T_{CK}) and then update the fixed delay code accordingly.

As illustrated in Figure 10, existing calibration approaches usually require stepping through every possible control value from the minimum to the maximum setting. This is necessary because conventional DLL systems lack the ability to reliably detect harmonic locking points, especially at the second harmonic and above, which may cause incorrect convergence. As a result, linear search must always begin at the smallest control value and increase step by step, requiring up to 2^{N} steps for an N-bit control value (e.g., 8 steps for N = 3).

In contrast, the subject technology provides full detection capability for harmonic locking conditions across the entire tuning range (e.g., using second detector 406 of Figure 4 or detector 700 of Figure 7A). This enhanced detection enables the implementation of a binary search calibration method, which greatly reduces the maximum number of search steps to N (e.g., three steps for N = 3), thereby improving calibration speed and overall system efficiency. The speed improvement from 2^{N} to N becomes more pronounced as N increases further. Furthermore, the subject technology also facilitates rapid recovery from disturbances. In the event of unexpected DLL disruptions that lead to harmonic locking or stuck locking, the system is capable of dynamically re-adjusting V_{CTRL} without requiring a full system reset or presetting the delay to a minimum value. This capability enhances the robustness of the DLL system and reduces lock acquisition time under real-world operating conditions.

While the above is a full description of the specific embodiments, various modifications, alternative constructions and equivalents may be used. Therefore, the above description and illustrations should not be taken as limiting the scope of the subject technology which is defined by the appended claims.

## Claims

1. An apparatus comprising:
a first circuit configured to receive an input clock signal and to generate an output clock signal by providing a first delay to the input clock signal;
a second circuit coupled to the first circuit and configured to sample propagation of the input clock signal within the first circuit and provide a first signal indicative of a propagation distance of the input clock signal;
a first detector coupled to the first circuit, the first detector being configured to determine a phase difference between the input clock signal and the output clock signal and to generate a second signal based on the phase difference;
a second detector coupled to the second circuit, the second detector being configured to determine a locking condition based on the first signal and to generate a third signal based on the locking condition; and
a controller coupled to the first detector and the second detector, the controller being configured to adjust the first delay based on at least one of the second signal and the third signal.

2. The apparatus of claim 1, wherein
the first circuit comprises a first stage configured to generate a first intermediate clock signal by providing a second delay to the input clock signal; and
the second circuit comprises a first sampling element coupled to the first stage and configured to sample the first intermediate clock signal and generate a first sampled value.

3. The apparatus of claim 2, wherein
the first signal comprises the first sampled value from the first sampling element.

4. The apparatus of any one of the claims 1 to 3, further comprising
a charge pump coupled to the controller and the first circuit, the charge pump being configured to adjust a control voltage applied to the first circuit based on the control signal.

5. The apparatus of any one of the claims 1 to 4, wherein
the locking condition comprises a stuck locking condition or a harmonic locking condition.

6. The apparatus of claim 5, wherein
the second detector is configured to compare the propagation distance of the input clock signal to a first threshold and to determine the stuck locking condition in response to the propagation distance being less than the first threshold.

7. The apparatus of claim 5 or 6, wherein
the second detector is configured to compare the propagation distance of the input clock signal to a second threshold and to determine the harmonic locking condition in response to the propagation distance being greater than the second threshold.

8. The apparatus of any one of the claims 1 to 7, wherein the
controller is configured to generate the control signal based on the third signal in response to a determination of the locking condition.

9. The apparatus of any one of the claims 1 to 8, wherein
the controller comprises a multiplexer.

10. The apparatus of any one of the claims 1 to 9, wherein
the controller is configured to generate a control signal based on at least one of the second signal and the third signal and
the control signal is configured to adjust the first delay.
